(19) Europäisches Patentamt

European Patent Office

Office européen des brevets

(11) **EP 1 006 659 A1**

(12) **EUROPEAN PATENT APPLICATION**

(43) Date of publication:
**07.06.2000 Bulletin 2000/23**

(51) Int. Cl.$^7$: **H03L 7/00**, H04B 1/40,
H03L 7/197, G06F 1/025

(21) Application number: **98403033.8**

(22) Date of filing: **03.12.1998**

(84) Designated Contracting States:
**AT BE CH CY DE DK ES FI FR GB GR IE IT LI LU
MC NL PT SE**
Designated Extension States:
**AL LT LV MK RO SI**

(71) Applicant: **MOTOROLA, INC.
Schaumburg, IL 60196 (US)**

(72) Inventors:
• **Khlat, Nadim
31270 Cugnaux (FR)**
• **Gorisse, Philippe
31490 Brax (FR)**

(74) Representative:
**Joly, Jean-Jacques et al
Cabinet Beau de Loménie
158, rue de l'Université
75340 Paris Cédex 07 (FR)**

(54) **Timer circuit, sequence generator arrangement, fractional-N PLL and method therefor**

(57)    A timer circuit (100) of a mobile phone (5) has a clock signal input (75) for providing an uncorrected clock signal from a crystal oscillator (50) of the phone (5) and a correction signal input (65) providing a correction signal indicating the difference between the uncorrected clock signal and a calibrated reference signal received from a base station. A timer (70) receives the uncorrected clock signal and counts the clock edges of the clock signal in order to provide an output signal (80) to be used in synchronising timing functions of the mobile with the base station. An accumulator (60) receives the uncorrected clock signal and the correction signal, and accumulates frequency error for providing supplemental signals (62,63) to increment or decrement the timer in dependence upon the frequency error. A sequence generator arrangement has a first portion arranged to process odd integer values of a periodic digital input signal for providing a first output, and a second portion arranged to process even integer values of the periodic digital input signal, for providing a second output. Combination logic is arranged to combine the first output and the second output in order to provide a sequence output. The first and the second portions may thus be clocked at half the reference frequency of the system in which the sequence generator arrangement is incorporated, e.g. a fractional-N phase locked loop.

*FIG.1*

EP 1 006 659 A1

**Description**

Field of the Invention

This invention relates to timer circuits, particularly but not exclusively to timer circuits for use in portable equipment, and to sequence generators, particularly but not exclusively to sequence generators incorporated in fractional-N Phase Locked Loops used in portable equipment.

Background of the Invention

In a mobile telephone or other portable equipment arranged to communicate over a Radio-Frequency (RF) air interface, an oscillating crystal is typically used to generate a frequency to be used as a datum for both an air interface timer and a Voltage-Controlled Oscillator (VCO) of the RF modulator/demodulator. In most cases the oscillation of the crystal is not accurate enough to provide the desired frequency, and some form of correction is required. An analogue phase locked loop (PLL) is typically coupled to the crystal, for providing a means by which the crystal oscillating frequency can be calibrated prior to use by the VCO and the air interface timer. The crystal frequency is calibrated by a correction signal which is derived from the difference between the uncorrected PLL output (the uncalibrated crystal frequency) and a known reference frequency received from a base station over the air interface. A varicap (variable capacitor) of the PLL is adjusted accordingly such that the crystal frequency is calibrated to the reference frequency.

A problem with this arrangement is that the PLL requires a number of discrete components, including the varicap, resistors and a Digital-to-Analogue converter. These components are expensive and cannot easily be integrated.

A known approach to address this problem involves the use of a fractional-N PLL to provide the correction arrangement for the VCO, the fractional-N PLL being more integrated and requiring fewer discrete components. This fractional-N PLL provides an adjustment to the VCO and operates at the frequency of the VCO.

A problem associated with fractional-N PLLs is that,particularly in battery operated equipment, there is a need to reduce the supply voltage to the PLL in order to reduce the power consumption of the equipment. This should preferably be achieved without any increase in amount of semiconductor material used.

Furthermore, there is a need to increase the (sampling) speed of the sequence accumulator or sequence generator which forms part of the PLL, in order to mitigate the effects of quantisation noise and self mixing problems, thus avoiding noise problems and possibly removing the need for digital pre-distortion.

A further problem is that the speed of the sequence generator, and in particular the speed of the logic circuitry therein, is in part dictated by voltage. Therefore by decreasing supply voltage in order to reduce power consumption, the sequence generator and hence the PLL becomes slower; and a trade-off must then be made between speed and power consumption.

Yet another problem is that a further PLL is required by the air interface timer, in order to ensure that time slots of the air interface protocol are accurately tracked by the mobile telephone. This further fractional-N PLL operates at the clock frequency of the circuitry (typically 13MHz) and adds further cost and complexity to the equipment.

It is an object of this invention to provide a timer circuit, sequence generator arrangement, Fractional-N PLL and method therefor, which mitigate the above-mentioned disadvantages.

Summary of the Invention

According to a first aspect of the present invention there is provided a timer circuit for a portable device arranged to communicate over an air interface according to a time slot protocol, the timer circuit comprising; a clock signal input for providing an uncorrected clock signal from a crystal oscillator; a correction signal input for providing a correction signal indicating the difference between the uncorrected clock signal and a frequency calibration signal received over the air interface; counting means, coupled to receive the uncorrected clock signal for counting a predetermined number of clock edges of the clock signal and for providing an output signal in dependence thereon, for use in synchronising timing functions of the portable device to the time slot protocol; and, correction means coupled to receive the correction signal, for accumulating frequency error and for providing supplemental signals to the counter means in dependence upon the frequency error.

Preferably the counting means is a timer, and the correction means is an accumulator, coupled to receive the uncorrected clock signal and further coupled to provide the supplemental signals to increment or decrement the timer in dependence upon the accumulated frequency error.

Preferably the output signal is a counter value, the synchronisation of the timing functions being provided using predetermined levels of the counter value. Alternatively the output signal is a pulse train arranged to provide clock pulses to a counter.

Alternatively the counter means is a register, and the correction means is an adder circuit coupled to receive the output signal from the register, for adding the output signal to the correction signals, such that the supplemental signals are update values which are used to update the register.

According to a second aspect of the present invention there is provided a method for correcting a timer circuit for a portable device arranged to communicate over an air interface according to a time slot protocol, the method comprising the steps of; providing an uncorrected clock signal from a crystal oscillator; providing a correction signal indicating the difference between the uncorrected clock signal and a frequency calibration signal received over the air interface; counting a predetermined number of clock edges of the uncorrected clock signal; providing an output signal indicating the number of clock edges counted, for use in synchronising timing functions of the portable device to the time slot protocol; accumulating frequency error using the correction signal; and, providing supplemental signals to adjust the counting of the clock edges in dependence upon the accumulated frequency error.

In this way a timer circuit is provided which provides correction of timing signals to synchronise the timing functions of the mobile to the base station, without the need for a dedicated Fractional-N PLL.

According to a third aspect of the present invention there is provided a sequence generator arrangement, comprising: a first portion arranged to process odd integer values of a periodic digital input signal, for providing a first output; a second portion arranged to process even integer values of the periodic digital input signal, for providing a second output; and, combination logic arranged to combine the first output and the second output in order to provide a sequence output.

Preferably the first and second portions each include an adder and a register. The adders of the first and second portions preferably each receive a cross-coupled input from the other portion. Preferably the first and second portions each include a further register, coupled between an output of the adder and a node from which the cross-coupling input for the other portion is taken.

According to a fourth aspect of the present invention there is provided a Fractional-N Phase Locked Loop, comprising at least one sequence generator arrangement as above.

Preferably the Fractional-N Phase Locked Loop comprises three cascaded sequence generator arrangements as above, and cascade combination logic arranged to combine the sequence outputs of the three sequence generator arrangements.

According to a fifth aspect of the present invention there is provided a method of producing a digital data sequence comprising the steps of: processing odd integer values of a periodic digital input signal using a first path, for providing a first output; processing even integer values of the periodic input signal using a second path, for providing a second output; and, combining the first output and the second output in order to provide a sequence output.

In this way a sequence generator arrangement, Fractional-N PLL and method are provided with improved speed and/or reduced power consumption.

Brief Description of the Drawings

An exemplary embodiment of the invention will now be described, for the purposes of illustration, with reference to the drawings in which:

FIG. 1 shows a mobile telephone incorporating a preferred embodiment of a timer circuit in accordance with the invention:

FIG. 2 shows a timing diagram of signals associated with the mobile telephone of FIG.1;

FIG. 3 shows an alternative embodiment of a timer circuit in accordance with the invention;

FIG. 4 shows a prior art sequence generator model;

FIG. 5 shows a block diagram of a sequence generator arrangement in accordance with the invention;

FIG. 6 shows a preferred embodiment of the sequence generator arrangement of FIG. 5, according to a first aspect of the invention;

FIG. 7 shows a preferred embodiment of the sequence generator arrangement of FIG. 5, according to a second aspect of the invention;

FIG. 8 shows a preferred embodiment of the sequence generator arrangement of FIG. 5, according to a third aspect of the invention; and,

FIG. 9 shows a Fractional N-PLL employing three sequence generator arrangements of FIG. 5 in cascaded configuration.

Detailed Description of Preferred Embodiments

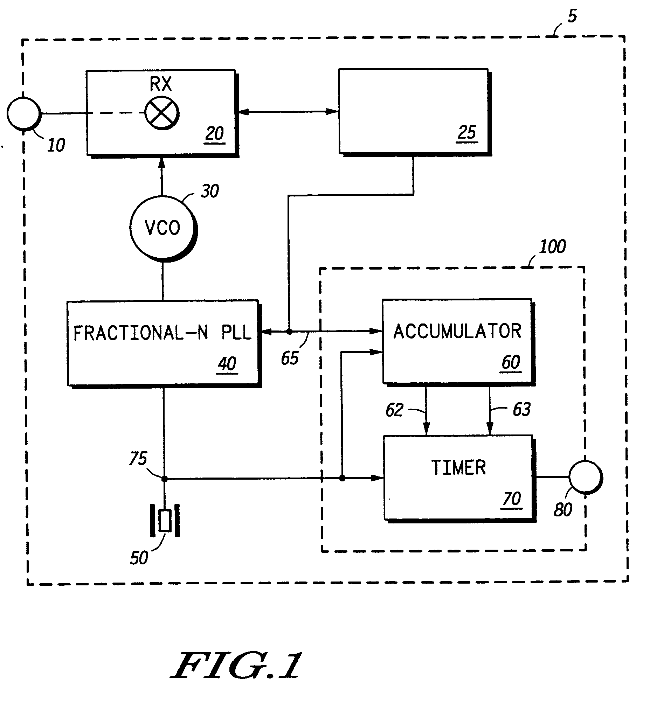

Preferred embodiments of timer circuits according to the invention will now be described. Referring to FIG. 1, there is shown a portion of a mobile telephone 5, including an input terminal 10, a Receive (Rx) stage 20, a processing stage 25, a Voltage Controlled Oscillator (VCO) 30, a Fractional-N type Phase-Locked-Loop (PLL) 40, a crystal 50 and a timer circuit 100.

The timer circuit 100 comprises an accumulator 60, a timer 70 and an output terminal 80.

The input terminal 10 is coupled to an antenna (not shown) for receiving a first Radio-Frequency (RF) signal from a base station (not shown) over an air interface.

The Rx stage 20 is coupled to receive the first RF signal from the input terminal 10, and is arranged to demodulate the received RF signal using a second RF signal received from the VCO 30, for providing a demodulated signal. The Rx stage 20 may also incorporate a Transmit (Tx) stage, thus providing an integrated RF interface.

The processing stage 25 includes processing circuitry and other digital and analogue circuitry, and is coupled to receive the demodulated signal and the second RF signal from the Rx stage 20, for comparing a parameter of the first RF signal (to be further described below) with a parameter of the second RF signal, and for providing a correction signal 65 in dependence upon the comparison, which is further described below.

The crystal 50 may be a quartz crystal or similar which oscillates freely without correction at a frequency in the region of 26Mhz. and provides an oscillation signal 75 (which has a frequency equal to the uncorrected oscillation frequency of the crystal 50) to the Fractional-N PLL 40.

The Fractional-N PLL 40 accumulates the oscillation signal 75 and provides a drive signal to drive the VCO 30. The Fractional-N PLL also receives the correction signal 65.

The accumulator 60 of the timer circuit 100 is also coupled to receive the oscillation signal 75 and the correction signal 65. The timer 70 is coupled to receive the oscillation signal 75 and to receive an increment signal 62 and a decrement signal 63 from the accumulator 60, for providing a timer output to an output terminal 80. The timer output may be a pulse train or a counter value.

In operation, the input terminal 10 receives a first Radio-Frequency (RF) signal from the base station (not shown) over the air interface. The first RF signal contains a reference data burst, in some systems this is known as a Frequency Control CHannel (FCCH) burst. This reference data burst provides a calibrated frequency reference, which is compared by the processing stage 25 with the second RF signal from the VCO 30. The result of the comparison is the correction signal 65, which indicates the amount of error between the calibrated frequency reference and the second RF signal.

The Fractional-N PLL 40 adjusts the accumulation of the oscillation signal 75 by the value of the correction signal 65. In this way the drive signal to the VCO 30 is corrected and the resulting second RF signal produced by the VCO 30 is also corrected (frequency calibrated).

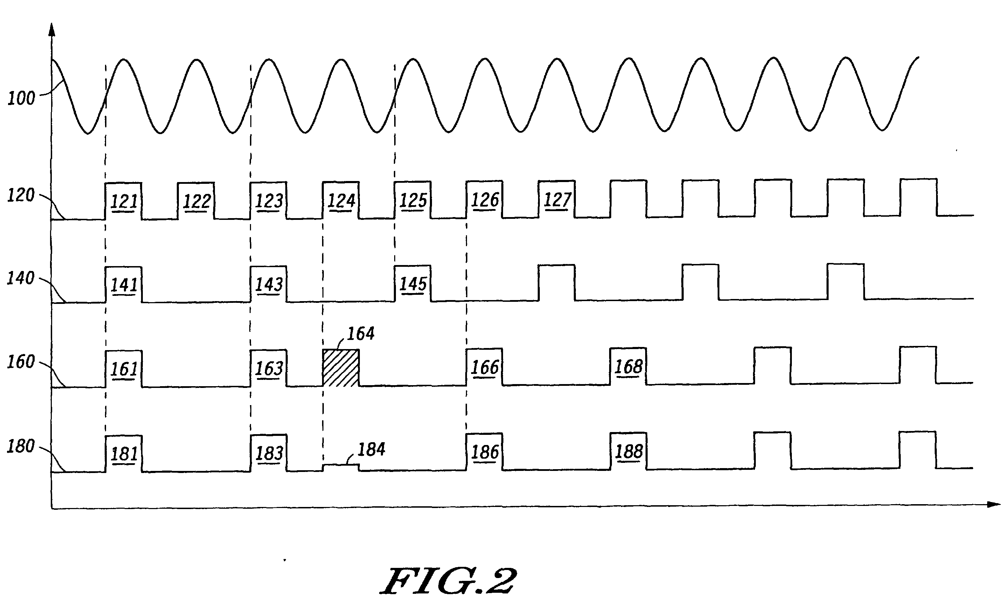

Referring now also to FIG. 2, there is shown a sinusoidal signal 100, which represents the (uncorrected) oscillation signal 75 from the crystal 50. The timer 70 receives the oscillation signal 75 and counts the clock edges, providing an output pulse when a predetermined number of clock edges have been counted. A pulse train 120 of FIG.2 reflects the occurrence of the clock edges.

In the preferred embodiment the crystal 50 has an approximate frequency of 26MHz and the desired timer output is 13Mhz, which is to be used as a system clock. Therefore the predetermined number of clock edges is two. Therefore an output pulse occurs when every second clock edge has been counted, as shown in a first output signal train 140 of FIG. 2.

Since the crystal 50 oscillates without correction, the first output signal train 140 will be subject to the same error as the oscillation of the crystal 50. Such an error must be corrected, such that an accurate pulse train (calibrated at 13MHz) or counter value is provided at the output terminal 80.

The output terminal 80 is typically coupled to time sensitive functions including the timing of the air interface protocol. The base station operates according to the air interface protocol, setting time slots in predetermined periods of time. The mobile telephone 5 must be synchronised to the protocol, so that it can transmit and receive signals in coordination with the time slots. Certain tolerance is allowed which is further described below, but if the mobile telephone 5 is outside of the tolerance limits, it will not be able to communicate with the base station.

In order to correct for this error, and ensure that the mobile telephone 5 is at least synchronised to within the tolerance limit, the accumulator 60 is used. The accumulator 60 counts the number of clock edges received from the crystal 50 (pulse train 120) and uses the received correction signal 65 to determine the number of clock edges/pulses to be accumulated, and the type of output that the accumulator 60 will provide to the timer 70.

The accumulator 60 is arranged to add up partial errors present in each clock edge, and provide an output to the timer 70 when the accumulated partial error equals one clock period. If the correction signal 65 indicates that the error is 1/X of the frequency f, where X is an integer, then the accumulator will provide an output when n = X , where n is the number of edges.

If X is not an integer, the accumulator 60 will provide an output when n > X, and will maintain the value of n - X, for use in the next accumulation sequence, such that no error is discounted from the correction. In this case the accumulator 60 may be a third or fourth order accumulator.

By way of example, if the correction signal 65 indicates that the frequency error is 5% (1/20) then the accumulator will send an output signal at every 20 clock edges (20 clock edges having 5% error provides an accumulated error of one clock period).

The timer 70 is either incremented or decremented depending upon whether the correction signal 65 indicates that the crystal 50 is running fast or slow. If the crystal 50 is slow, an increment signal 62 is provided, and if the crystal 50 is fast, then a decrement signal 63 is provided.

In the case of a slow running crystal, a second output signal train 160 of FIG. 2 provides an example of an increment. For pulses 121-123 of the pulse train 120, the second output signal train 160 shows the normal result of the timer circuit 70. However, after pulse 123, the accumulator 60 has accumulated enough partial errors to justify an increment signal 62. The increment signal causes the timer circuit 70 to be incremented by one count, such that when the pulse 124 is input at the timer 70, the count reaches two and an output pulse 164 is provided. The timer 70 then continues as normal, triggering an output pulse at every second clock edge (166, 168..).

In the case of a fast running crystal, a third output signal train 180 of FIG. 2 provides an example of a decrement. For pulses 121-123 of the pulse train 120, the third output signal train 180 shows the normal result of the timer 70. However, after pulse 123, the accumulator 60 has accumulated enough partial errors to justify a decrement signal 63. The decrement signal causes the timer 70 to not count the pulse 124. The timer 70 then continues counting as normal, triggering an output pulse at every second clock edge (186, 188..).

In this way the output signal train provided by the timer 70 to the output terminal 80 is periodically adjusted in order to account for the frequency error of the crystal 50. The typical circuitry (not shown) which is coupled to the output terminal 80 for providing timing functions of the air interface protocol is digital and therefore not sensitive to variations in the output pulse train due to the increment and decrement signals 62 and 63 respectively.

As stated above, the air interface protocol timing functions of the mobile telephone 5 need only be synchronised to the base station within a given tolerance. For example, the accuracy required in the GSM specification is Tsymbol/16, where Tsymbol is the time period of one symbol of data.

The timer circuit 100 described above operates by effectively inserting or removing a 26MHz pulse into the 13MHz clock signal. Therefore an error of up to one half period could still be present in the clock signal after correction. This amounts to a timing error of 1/26MHz, which in the GSM specification is approximately equal to 1/96/Tsymbol, or Tsymbol/96, which is much smaller than the allowed tolerance of Tsymbol/16. Therefore the timer circuit 100 easily achieves the amount of error correction necessary to ensure calibration of the mobile telephone 5 with the air interface protocol of the base station.

In an alternative arrangement of the timer circuit 100, the output of the timer 70 may be the counted value, rather than a pulse train. In this case, the timer 70 may be arranged to count to a much higher number than 2. The increment or decrement signal works in the same way, with the same error of up to one half period.

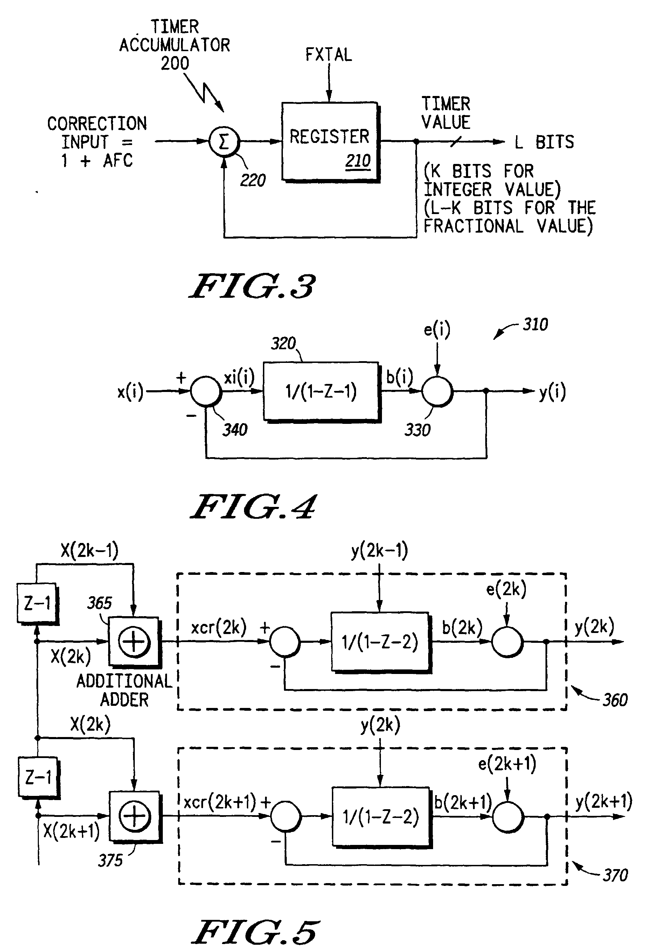

Referring now also to FIG. 3, there is shown an alternative embodiment of the invention in the form of a timer accumulator 200, which is an alternative to the timer circuit 100. The timer accumulator comprises a register 210 and a summation block 220. The register 210 is coupled to receive the uncorrected signal from the crystal 50, and provides, at each clock edge, an output signal indicating the register value. The summation block 220 is coupled to receive the output signal from the register 210, and a correction signal from the processing stage 25, for providing an input signal to the register 210. The correction signal has the value 1+afc, where afc indicates the error.

Therefore the timer accumulator 200 performs the following function:-

$$\text{Timer value (n) = Timer value (n-1) + (1+afc), for each crystal clock edge n}$$

So where there is no error (afc=0), the timer values will be 0, 1, 2, 3. etc..

Where there is an error of -20% (afc=+1/5), the timer values will be:-

$$0, 1.2, 2.4, 3.6, 4.8, 6, \text{etc..}$$

In this way the error is added to the register 210 at each clock pulse of the uncorrected signal, and is fed back into the register at the next clock pulse, along with the new value of the register, thus accumulating the error at the same time as providing the counter value.

It is also possible to count using a frequency which is a multiple or a fraction of the uncorrected clock frequency, by altering the integer value of the correction signal. For example, if the correction signal is (1/2+afc), the timer accumulator 200 will count at 13MHz, from a 26MHz crystal (0, 0.5, 1.0, 1.5, 2.0 etc..).

This is useful in mobile telephones which are adapted to operate using more than one air interface protocol, where the base frequencies of the timing protocols differ. If the base frequencies are similar, they can both be provided using differing afc values. However, if they are dissimilar, they can both be provided by altering the integer value of the correction signal.

It will be appreciated that alternative embodiments to the one described above are possible. For example, the timer circuit represents a hardware embodiment of the invention. It is possible to provide a software embodiment, whereby the functions of the timer circuit 100 are provided by a software program.

Furthermore the frequency of the signals and the predetermined numbers used for counting and accumulating may be different from those described above.

Similarly, the output of the timer 70 may be used for purposes other than providing the timing functions to synchronise the mobile telephone 5 to the base station.

Preferred embodiments of sequence generators according to the present invention will now be described.

Referring to FIG. 4, there is shown a prior art sequence generator 310, which is a first order sequence generator having a single register 320, and first and second summation blocks 330 and 340 respectively.

The first summation block 330 adds an output $b(i)$ of the register 320 to a further value $e(i)$, to provide a summed result $y(i)$.

The second summation block 340 adds a value $x(i)$ to the summed result $y(i)$, to provide a further summed result $xi(i)$, provided as an input to the register 320. The register 320 is arranged to add its previous result $b(i-1)$ to the input $xi(i)$, to provide the output $b(i)$. These can be represented by the following equations:-

$$xi(i) = x(i) - y(i) \hspace{4cm} \text{Equation 1}$$

$$b(i) = b(i-1) + xi(i) \hspace{4cm} \text{Equation 2}$$

$$y(i) = b(i) + e(i) \hspace{4cm} \text{Equation 3}$$

Using Equation 1, Equation 2 can be re-written as:-

$$b(i) = b(i-2) + \{x(i-1) - y(i-1)\} + \{x(i) - y(i)\} \hspace{2cm} \text{Equation 4}$$

Then, if $i = 2k$, where k is an integer, Equation 4 becomes:-

$$b(2k) = b(2k-2) + \{x(2k-1) - y(2k-1)\} + \{x(2k) - y(2k)\} \hspace{1.5cm} \text{Equation 5}$$

Similarly, if $i = 2k-1$, Equation 4 becomes:-

$$b(2k-1) = b(2k-3) + \{x(2k-2) - y(2k-2)\} + \{x(2k-1) - y(2k-1)\} \hspace{1cm} \text{Equation 6}$$

Equations 5 and 6 can be used as a basis for constructing an alternative sequence generator arrangement according to the present invention having a first sequence generator dealing with even integers of k and a second sequence generator dealing with odd integers of k. In such an arrangement however, cross coupling terms are necessary. For the first register the term having odd integers of k, namely $\{x(2k-1) - y(2k-1)\}$ must be provided. Similarly, for the second register the term having even integers of k, namely $\{x(2k-2) - y(2k-2)\}$ must be provided.

In order to simplify the cross coupling terms above, Equations 5 and 6 may be rearranged as follows:-

$$b(2k) = b(2k-2) + xcr(2k) - y(2k-1) - y(2k) \hspace{2cm} \text{Equation 7}$$

where $xcr(2k) = x(2k-1) + x(2k)$

$$b(2k+1) = b(2k-1) + \{x(2k) - y(2k)\} + \{x(2k+1) - y(2k+1)\} \text{ leading to:-}$$

$$b(2k+1) = b(2k-1) + xcr(2k+1) - y(2k) - y(2k+1) \hspace{1.5cm} \text{Equation 8}$$

where $xcr(2k+1) = x(2k) + x(2k+1)$

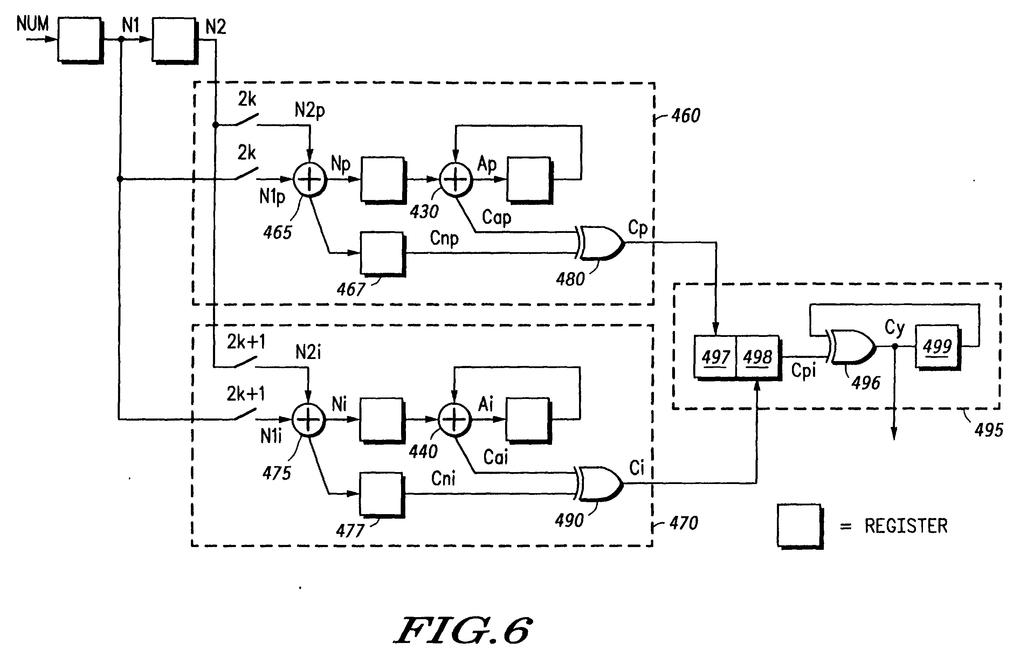

Referring now to FIG. 5, there is shown a first sequence generator arrangement 350 according to the present invention, in which Equations 7 and 8 have been implemented. A first sequence generator 360 of the arrangement implements even integers of k, and a second sequence generator 370 implements odd integers of k. The first and second sequence generators 360 and 370 respectively operate at a frequency of fref/2, where fref is a reference frequency of the system in which the sequence generator arrangement 350 is incorporated.

A third adder 365 and a fourth adder 375 are provided in order to provide the terms xcr(2k) and xcr(2k+1) respectively. The third and fourth adders 365 and 375 respectively also operate at fref/2. However, due to the cross carry terms y(2k-1) and y (2k), the arrangement 350 does not operate at fref/2, and a fully parallel structure is not provided in FIG. 5.

Referring now also to FIG. 6, there is shown a further sequence generator arrangement 400 according to the present invention, which is frilly parallel, and in which each component operates at fref/2. This is achieved by the use of a carry output from each of the first and second adders (in FIG. 6, the first and second sequence generators are numbered 460 and 470 respectively, the first and second adders are numbered 430 and 440 respectively, and third and fourth adders are numbered 465 and 475 respectively).

A first carry output Cnp provides, via a register 467, the Most Significant Bit (MSB) of the output from the third adder 465, to a first input of an XOR gate 480. The XOR gate 480 has an output Cp and a second input provided by an output, Cap, of the first adder (430) of the first sequence generator 460.

Similarly a second carry output Cni provides, via a register 477, the Most Significant Bit (MSB) of the output from the fourth adder 475, to a first input of an XOR gate 490. The XOR gate 490 has an output Ci and a second input provided by an output, Cai, of the second adder (440) of the second sequence generator 470.

In this way the outputs Cp and Ci of the XOR gates 480 and 490 respectively each indicate whether an overflow has occurred in either one of their respective adders. If neither or both adders have overflowed, the result is logical 0, and if one or the other has overflowed, the result is logical 1.

The outputs Cp and Ci are provided to a further logic arrangement 495, comprising a further XOR gate 496, input registers 497 and 498 both coupled in a First-in First-Out (FIFO) configuration to an input of the XOR gate 496 and an output register 499 coupled to the output of the XOR gate 496. The logic arrangement performs the following function:-

$Cy(i) = Cy(i-1) - Cpi(i)$ where $Cy(i)$ is the output of the XOR gate 496 and Cpi is the serialisation of both carry outputs Cp and Ci. This operation is required to cancel a transferred carry from one sequence generator to the other. This is illustrated in the following table, which shows the relationship between $Cy(i-1)$, $Cpi(i)$ and $Cy(i)$:

| Cy(i-1) | Cpi(i) | Cy(i) | Cause |
|---------|--------|-------|-------|
| 0 | 0 | 0 | No carry |
| 0 | 1 | 1 | A carry has occurred |
| 1 | 1 | 0 | A transferred carry has occurred |
| 1 | 0 | 1 | Double *and* transferred carry have occurred, the net result is one carry. |

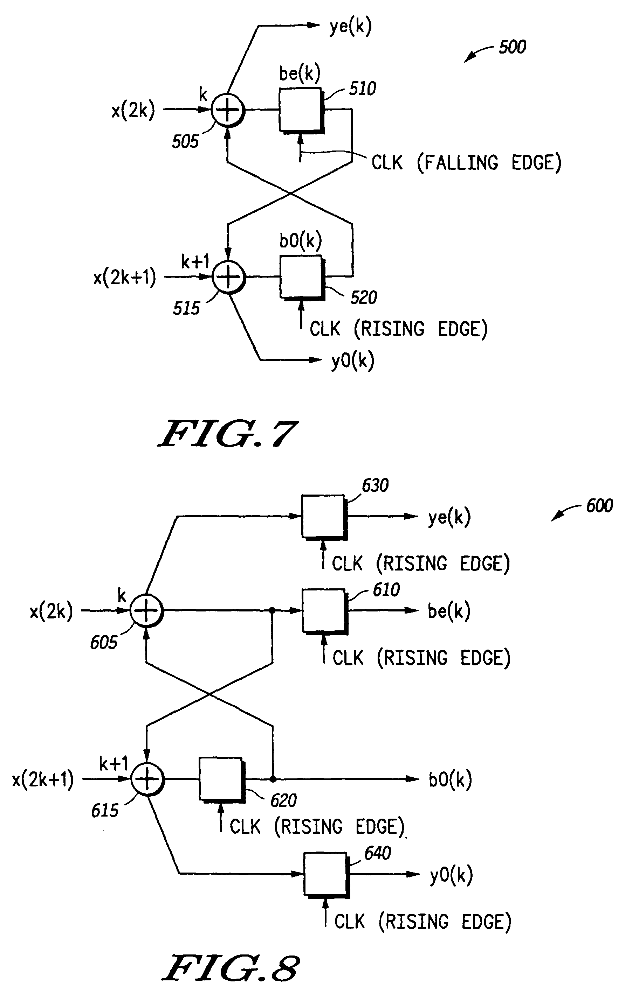

Referring now also to FIG. 7, there is shown an alternative non-parallel structure, of sequence generator according to the present invention, using two adders rather than four.

Again, combining Equations 1 and 2 above, leads to:-

$$b(i) = b(i-1) + x(i) - y(i) \qquad \text{Equation 9}$$

Rewriting for i =2k and i = 2k+1 :-

$$b(2k) = b(2k-1) + x(2k) - y(2k) \qquad \text{Equation 10}$$

and

$$b(2k+1) = b(2k) + x(2k+1) - y(2k+1) \qquad \text{Equation 11}$$

Taking be(k) =b(2k) (even sequence generator) and bo(k+1) = b(2k+1) (odd):-

$$be(k) = bo(k) + x(2k) - ye(k) \qquad \text{Equation 12}$$

7

and

$$bo(k+1) = be(k) + x(2k+1) - yo(k+1)$$

Equation 13

Equations 12 and 13 are readily implemented using a structure such as the sequence generator 500 shown in FIG. 7, comprising a be adder 505 and a be register 510, and a bo adder 515 and a bo register 520. The outputs of the be register 510 and a bo register 520 are cross coupled to the inputs of bo and be adders 515 and 505 respectively.

The be and bo adders 505 and 515 respectively have their inputs changing at a frequency of fref/2. However, because of the mutual cross coupling, there is a 1/fref maximum settling time for one input only, due to the change of bo(k) or be(k) delayed by 1/fref with respect to x(2k) and x(2k+1). To reduce this problem, a further implementation is shown in FIG. 8.

Referring to FIG. 8, there is shown a further sequence generator arrangement 600 according to the present invention, using a be adder 605 and a be register 610, a bo adder 615 and a bo register 620, and two further registers 630 and 640.

The be register 610 is placed in the arrangement 600 after the cross coupling input to the bo adder 615. The 605 be adder adds x(2k) and the bo(2k) output of the register 620, to provide an adder output be(k) which has a finite settling time. The x(2k) and the bo(2k) inputs are fixed at this time. The adder output be(k) has a number of intermediate results binte (intermediate) starting with the result after setting of the least significant bit (LSB) and changing one bit at a time up to the Most Significant Bit (MSB). This is a typical arrangement for an adder having carry propagation or carry-look ahead type of operation.

The bo adder 615 then adds x(2k+1) bit by bit as soon as each appropriate bit of the intermediate results binte are set. The output of the adder 615 is also subject to a settling time from the setting of the LSB to the MSB, but because the bo adder 615 operates on the bits in the same way (from LSB to MSB) the critical path delay is equal to the maximum delay propagation of the 605 adder and the delay of one carry propagation for the adder 615.

In this way the overall settling time of the arrangement 600 is reduced. The two further registers 630 and 640 provide the necessary adjustment for the position of the be register 610. In this way the critical path delay of the arrangement 600 is equal to the maximum delay propagation of the be (even) adder 605 and the delay of one carry propagation for the bo (odd) adder 615.

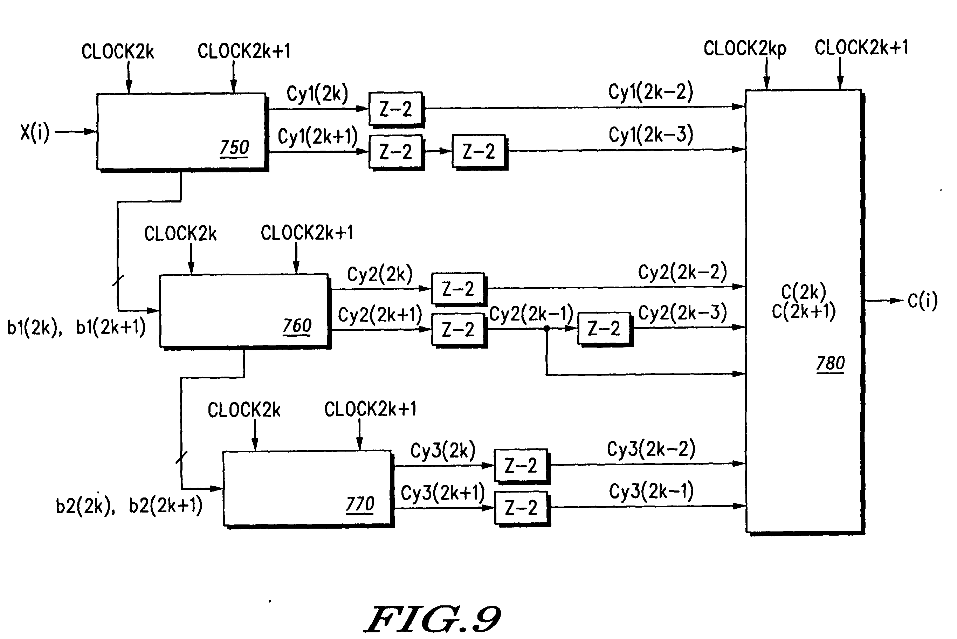

Referring now also to FIG. 9 there is shown a Fractional-N PLL according to an embodiment of the present invention having three sequence generator arrangements, 750, 760 and 770 as described above, in cascaded configuration. Re-combination logic 780 receives outputs from the arrangements 750, 760 and 770, for providing a combined output sequence.

It will be appreciated that alternative embodiments to the one described above are possible. For example, the precise structure of the arrangements described above, including the logic portions, may be varied from those described above, whilst maintaining the design methodology embodied in FIG. 5.

Furthermore the number of cascaded arrangements used to form the Fractional-N PLL may differ from the three arrangements shown in FIG. 9.

**Claims**

1. A timer circuit for a portable device arranged to communicate over an air interface according to a time slot protocol, the timer circuit comprising;

   a clock signal input for providing an uncorrected clock signal from a crystal oscillator;
   a correction signal input for providing a correction signal indicating the difference between the uncorrected clock signal and a frequency calibration signal received over the air interface;
   counting means, coupled to receive the uncorrected clock signal for counting a predetermined number of clock edges of the clock signal and for providing an output signal in dependence thereon, for use in synchronising timing functions of the portable device to the time slot protocol; and,
   correction means coupled to receive the correction signal, for accumulating frequency error and for providing supplemental signals to the counter means in dependence upon the frequency error.

2. The timer circuit of claim 1 wherein the counting means is a timer, and the correction means is an accumulator, coupled to receive the uncorrected clock signal and further coupled to provide the supplemental signals to increment or decrement the timer in dependence upon the accumulated frequency error.

3. The timer of claim 1 or claim 2 wherein the output signal is a counter value, the synchronisation of the timing functions being provided using predetermined levels of the counter value.

**4.** The timer of claim 1 or claim 2 wherein the output signal is a pulse train arranged to provide clock pulses to a counter.

**5.** The timer circuit of claims 1, 2 or 3 wherein the counter means is a register, and the correction means is an adder circuit coupled to receive the output signal from the register, for adding the output signal to the correction signals, such that the supplemental signals are update values which are used to update the register.

**6.** A method for correcting a timer circuit for a portable device arranged to communicate over an air interface according to a time slot protocol, the method comprising the steps of;

> providing an uncorrected clock signal from a crystal oscillator;
> providing a correction signal indicating the difference between the uncorrected clock signal and a frequency calibration signal received over the air interface;
> counting a predetermined number of clock edges of the uncorrected clock signal;
> providing an output signal indicating the number of clock edges counted, for use in synchronising timing functions of the portable device to the time slot protocol;
> accumulating frequency error using the correction signal; and,
> providing supplemental signals to adjust the counting of the clock edges in dependence upon the accumulated frequency error.

**7.** A sequence generator arrangement, comprising:-

> a first portion arranged to process odd integer values of a periodic digital input signal, for providing a first output;
> a second portion arranged to process even integer values of the periodic digital input signal, for providing a second output; and,
> combination logic arranged to combine the first output and the second output in order to provide a sequence output.

**8.** The arrangement of claim 7 wherein the first and second portions each include an adder and a register.

**9.** The arrangement of claim 8 wherein the adders of the first and second portions each receive a cross-coupled input from the other portion.

**10.** The arrangement of claim 9 wherein the first and second portions each include a further register, coupled between an output of the adder and a node from which the cross-coupling input for the other portion is taken.

**11.** A Fractional-N Phase Locked Loop, comprising at least one sequence generator arrangement as claimed in any of claims 7, 8, 9 or 10.

**12.** A Fractional-N Phase Locked Loop, comprising three cascaded sequence generator arrangements as claimed in any of claims 7, 8, 9 or 10, and cascade combination logic arranged to combine the sequence outputs of the three sequence generator arrangements.

**13.** A method of producing a digital data sequence comprising the steps of:-

> processing odd integer values of a periodic digital input signal using a first path, for providing a first output;
> processing even integer values of the periodic input signal using a second path, for providing a second output; and,
> combining the first output and the second output in order to provide a sequence output.

**FIG.1**

**FIG.2**

TIMER
ACCUMULATOR
200

CORRECTION
INPUT =
1 + AFC

FXTAL

$\Sigma$

220

REGISTER
210

TIMER
VALUE

L BITS

(K BITS FOR
INTEGER VALUE)
(L-K BITS FOR THE
FRACTIONAL VALUE)

*FIG.3*

310

x(i)

+

$-$

xi(i)

340

320

$1/(1-Z-1)$

b(i)

330

e(i)

y(i)

*FIG.4*

X(2k-1)

Z-1

365

X(2k)

ADDITIONAL
ADDER

xcr(2k)

+

$-$

y(2k-1)

$1/(1-Z-2)$

b(2k)

e(2k)

y(2k)

360

X(2k)

Z-1

X(2k+1)

375

xcr(2k+1)

+

$-$

y(2k)

$1/(1-Z-2)$

b(2k+1)

e(2k+1)

y(2k+1)

370

*FIG.5*

*FIG.6*

☐ = REGISTER

ye(k)

be(k)

510

x(2k) →— k ⊕ 505

CLK (FALLING EDGE)

b0(k)

520

x(2k+1) →— k+1 ⊕ 515

CLK (RISING EDGE)

y0(k)

*FIG.7*

630

ye(k)

CLK (RISING EDGE)

610

x(2k) →— k ⊕ 605

be(k)

CLK (RISING EDGE)

x(2k+1) →— k+1 ⊕ 615

620

b0(k)

CLK (RISING EDGE)

640

y0(k)

CLK (RISING EDGE)

*FIG.8*

EP 1 006 659 A1

*FIG.9*

European Patent
Office

**EUROPEAN SEARCH REPORT**

Application Number

EP 98 40 3033

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US 5 493 700 A (HIETALA ALEXANDER W ET AL) 20 February 1996 (1996-02-20) * column 2, line 28 - column 4, line 43; figures 2,3 * | 1,4,6 | H03L7/00 H04B1/40 H03L7/197 G06F1/025 |
| A | US 5 745 848 A (ROBIN JOHN F) 28 April 1998 (1998-04-28) * column 1, line 66 - column 9, line 40; figures * | 1,6 | |
| A | EP 0 726 508 A (NOKIA MOBILE PHONES LTD) 14 August 1996 (1996-08-14) * column 2, line 42 - column 11, line 35; figures * | 1,6 | |
| A | WO 97 36375 A (ADVANCED MICRO DEVICES INC) 2 October 1997 (1997-10-02) * page 4, line 1 - page 10, last last; figures 3-6 * | 1,6 | |
| A | DE 28 12 774 A (HEIL GEORG DIPL PHYS DR) 27 September 1979 (1979-09-27) * the whole document * | 1,6 | **TECHNICAL FIELDS SEARCHED (Int.Cl.6)** H03L H03J H04B G06F |

~~The present search report has been drawn up for all claims~~

| Place of search | Date of completion of the search | Examiner |
|---|---|---|
| THE HAGUE | 12 May 1999 | BALBINOT H. |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

| | |
|---|---|
| European Patent Office | **Application Number**<br>EP 98 40 3033 |

---

## CLAIMS INCURRING FEES

The present European patent application comprised at the time of filing more than ten claims.

☐ Only part of the claims have been paid within the prescribed time limit. The present European search report has been drawn up for the first ten claims and for those claims for which claims fees have been paid, namely claim(s):

☐ No claims fees have been paid within the prescribed time limit. The present European search report has been drawn up for the first ten claims.

---

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1 - 6

# EP 1 006 659 A1

## ANNEX TO THE EUROPEAN SEARCH REPORT
## ON EUROPEAN PATENT APPLICATION NO.　　　EP 98 40 3033

This annex lists the patent family members relating to the patent documents cited in the above-mentioned European search report.
The members are as contained in the European Patent Office EDP file on
The European Patent Office is in no way liable for these particulars which are merely given for the purpose of information.

12-05-1999

| Patent document cited in search report | | Publication date | Patent family member(s) | | Publication date |
|---|---|---|---|---|---|
| US 5493700 | A | 20-02-1996 | BR 9405977 A | | 09-01-1996 |
| | | | CA 2150818 A,C | | 04-05-1995 |
| | | | CN 1116021 A,B | | 31-01-1996 |
| | | | DE 4498261 C | | 22-07-1999 |
| | | | DE 4498261 T | | 21-12-1995 |
| | | | FR 2711868 A | | 05-05-1995 |
| | | | GB 2289383 A,B | | 15-11-1995 |
| | | | JP 8505508 T | | 11-06-1996 |
| | | | SE 9502306 A | | 29-08-1995 |
| | | | SG 44455 A | | 19-12-1997 |
| | | | WO 9512253 A | | 04-05-1995 |
| US 5745848 | A | 28-04-1998 | AU 1483297 A | | 11-09-1997 |
| | | | BR 9701152 A | | 15-12-1998 |
| | | | DE 19708797 A | | 06-11-1997 |
| | | | FR 2745674 A | | 05-09-1997 |
| | | | GB 2310966 A | | 10-09-1997 |
| EP 0726508 | A | 14-08-1996 | GB 2297854 A | | 14-08-1996 |
| | | | JP 8248156 A | | 27-09-1996 |
| | | | US 5740129 A | | 14-04-1998 |
| WO 9736375 | A | 02-10-1997 | US 5923704 A | | 13-07-1999 |
| DE 2812774 | A | 27-09-1979 | NONE | | |

EPO FORM P0459

For more details about this annex : see Official Journal of the European Patent Office, No. 12/82

**European Patent Office** | **LACK OF UNITY OF INVENTION SHEET B** | **Application Number** EP 98 40 3033

The Search Division considers that the present European patent application does not comply with the requirements of unity of invention and relates to several inventions or groups of inventions, namely:

1. Claims: 1-6

   A timer circuit and a method for correcting a timer circuit

2. Claims: 7-13

   A sequence generator arrangement and a method of producing a digital data sequence